Europäisches Patentamt

European Patent Office

Office européen des brevets

(11) Publication number: **0 203 493 B1**

## EUROPEAN PATENT SPECIFICATION

(45) Date of publication of patent specification: **02.12.92**　(51) Int. Cl.⁵: **H01L 29/80**, H01L 29/36, H01L 29/205

(21) Application number: **86106814.6**

(22) Date of filing: **20.05.86**

(54) Field effect transistor.

(30) Priority: **20.05.85 JP 108850/85**

(43) Date of publication of application:
**03.12.86 Bulletin 86/49**

(45) Publication of the grant of the patent:
**02.12.92 Bulletin 92/49**

(84) Designated Contracting States:
**DE FR GB NL**

(56) References cited:
**EP-A- 0 055 968**

**IEEE ELECTRON DEVICE LETTERS, vol. EDL-4, no. 1, January 1983, pages 5-8, IEEE, New York, US; T.P. PEARSALL et al.: "Selectively-doped A1 0.48In0.52As/Ga0.47In0.53As heterostructure field effect transistor"**

**PROCEEDINGS IEEE/CORNELL CONFERENCE ON ADVANCED CONCEPTS IN HIGH SPEED SEMICONDUCTOR DEVICES AND CIRCUITS, ITHACA, New York, US, 29th-31st July 1985, pages 92-101, New York, US; T. ITOH et al.: "A recessed gate A1**

**0.48In0.52As/Ga0.47In0.53As modulation doped field effect transistor"**

**Idem**

(73) Proprietor: **SUMITOMO ELECTRIC INDUSTRIES LIMITED**
**No. 15, Kitahama 5-chome, Higashi-ku Osaka-shi, Osaka 541(JP)**

(72) Inventor: **Sasaki, Goro Osaka Works, Sumitomo Elec.Ind.Ltd.**
**1-3, Shimaya 1-chome Konohana-ku Osaka-shi Osaka-fu(JP)**

(74) Representative: **Füchsle, Klaus, Dipl.-Ing. Hoffmann . Eitle & Partner Patentanwälte Arabellastrasse 4 W-8000 München 81(DE)**

Rank Xerox (UK) Business Services

## Description

The present invention relates to a field effect transistor, comprising a substrate made of semiinsulator or semiconductor of one conductivity type; working layers formed on the substrate; a source region and a drain region provided in the working layer and a channel region between the source and drain region; and a gate electrode formed on the channel region, said working layers comprising a first semiconductor layer of mixed crystal formed on the substrate and a second semiconductor layer formed on the first semiconductor layer and made of mixed crystal containing n-type impurity in such a manner that the density of the impurity is lower in the region near the gate electrode than in the region near the first semiconductor layer.

Such a transistor is known from EP-A-0 555 968.

There has been proposed a field effect transistor (referred to as FET) comprising a first layer made of Gallium, Indium and Arsenide ($Ga_{0.47}$ $In_{0.53}$ As referred to as Ga In As) mixed crystal and a second layer made of non-doped Aluminium, Indium and Arsenide ($Al_{0.48}$ $In_{0.52}$ Ao referred to as Al In As) mixed crystal on the first layer and third layer made of n-doped Al In As mixed crystal formed on the second layer. (C.Y. Chen, IEEE, ELECTRON DEVICE LETTERS, vol. EDL 3, No. 6, June 3).

In the FET of the above type, a two dimensional electron gas is formed in the Ga In As layer, since the electron affinity of the Al In As layer is smaller than the affinity of Ga In As layer and n-type impurities are selectively doped into the Al In As layer. The mobility of electrons is affected by scattering due to impurities. In the FET of the above type, impurities are doped into the Al In As layer while the two dimensional electron gas is in the Ga In As layer. Thus, the two dimensional electron gas has high mobility since the scattering due to impurities is remarkably suppressed. This two dimensional electron gas acts as a channel between the source and drain, namely the drain current flows through the two dimensional electron gas from the drain to the source. The drain current is varied by the applied voltage to the gate, since the density of the two dimensional electron gas is varied by the applied voltage to the gate. The FET of the above type has a high transconductance, since the two dimensional electron gas which acts as the channel has a high mobility.

The electrons in the two dimensional electron gas of the heterojunction interface between Al In As mixed crystal layer and Ga In As mixed crystal layer can have a higher mobility about 13.000 $cm^2$/V.sec under a room temperature than the electron mobility in the hetero junction between the Ga As layer and Al Ga As mixed crystal layer disclosed in the Japanese patent publication 53714/1984 and Japanese Journal of Applied Physics vol.19, 1980 L225. FETs using the hetero junction between Al In As layer and Ga In As layer to which the present invention pertains can provide a higher transconductance and high speed operation than the FET using Al Ga As/Ga As heterojunction.

FETs using the hetero junction between Al In As layer and Ga In As layer have been disclosed in IEEE Electron Device Letters EDL Vol. 1-8 page 154, wherein the non-doped Al In As layer is formed on the Ga In As layer doped with n-type impurities and a gate electrode is formed on the Al In As layer. The FETs of the above type are effective to increase the gate break down voltage. However, in these FETs, the two dimensional electron gas is not included because n-type impurities are not doped into the Al In As layer. The electron mobility under the room temperature of the Ga In As layer which acts as the channel is low because of a high density of n-type impurities such as 1.2 x $10^{17}$ $cm^{-3}$ in Ga In As layer which causes the electrons flowing between the source and drain of the FET to be scattered by the ionized n-type impurities. Therefore, in the FETs of the above type, it cannot be expected to increase the transconductance and high speed operation.

An object of the present invention is to provide a field effect transistor which is able to operate with a high transconductance and a high speed operation.

According to one aspect of the invention, the field effect transistor initially defined is characterized in that the mixed crystal in said first semiconductor layer is GaInAs; the mixed crystal of said second semiconductor layer is Al In As; and said n-type impurity is substantially absent in a region of at least 5 nm depth measured from the surface of the second semiconductor layer.

According to another aspect of the invention, there is provided a field effect transistor comprising: a substrate made of semiinsulator or semiconductor of one conductivity type; working layers formed on the substrate; a source region and drain region provided in the working layer and channel region between the source and drain region; and a gate electrode formed on the channel region, said working layers comprising a first semiconductor layer of mixed crystal formed on the substrate, a second semiconductor layer of non-doped mixed crystal formed on the first semiconductor layer, and a third semiconductor layer of mixed crystal containing n-type impurity in such a manner that the density of the impurity in the region near the gate electrode is lower than the density of the n-type impurity in the region near the second semiconductor layer, characterized in that the mixed crystal of said first layer is Ga In As; the mixed crystal of said second and third layers is Al In As; and said n-type impurity is substantially absent in a region of at least 5 nm depth measured from the surface of the second semiconductor layer.

For a better understanding of the invention and to show how the same may be carried into effect, reference will now be made, by way of example, to the accompanying drawings, in which:

Figs. 1 and 2 are cross-sectional views showing a preferred embodiment of a field effect transistor according to the present invention;

Fig. 3 and 4 show respectively distribution of n-type impurity in the Al In As semiconductor layer;

Fig. 5 is a graph showing a characteristic curve of the current and voltage in the Schottky junction of Al In As layer to which Si of $1 \times 10^{17}$ $cm^{-3}$ is doped;

Fig. 6 is a graph showing a characteristic curve of the current and voltage in the Schottky junction of Al In As layer to which no impurity is doped in the region of 12 nm from the upper surface of Al In As layer;

Fig. 7 is a graph showing a characteristic curve of the drain current and the drain voltage of a conventional field effect transistor,

Fig. 8 is a graph showing a characteristic curve of the drain current and the drain voltage of the FET according to the present invention.

In general, in the Schottky junction comprising semiconductor material containing n-type impurities of a density $N_D$, the backward breakdown voltage is proportional to the inverse of the density $N_D$. Decrement of the impurity density in the semiconductor improves the backward breakdown voltage in the Schottky junction. However, decrement of the density of the n-type impurity in Al In As layer decreases the two dimensional electron gas in Ga In As layer, thereby resulting in less FET performance such as a high source resistance, less gate swing amplitude.

The electron density of the two dimensional electron gas near the heterojunction in the semiconductor layer near the substrate can be increased to a maximum value defined by the electron affinity in the heterojunction under the thermal equilibrium by enhancing the n-type impurity of the Al In As layer.

In the FETs hereinafter described the density of the n-type impurity in Al In As layer is changed so that the density near the substrate is increased, thereby developing two dimensional electron gas of a high electron density and the density of the n-type impurity in the Al In As layer is made low near the gate electrode so as to provide a gate electrode of a high break down voltage.

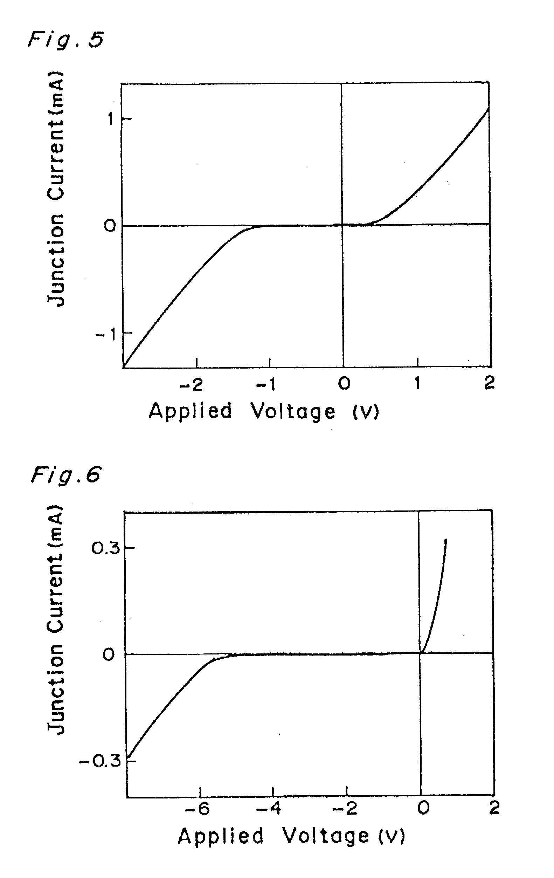

According to an experiment conducted by the inventor, in case a Schottky junction is formed on Al In As layer which is formed by MBE method on the In P substrate of 480°C, when the density of the n-type impurity which is Si exceeds $1 \times 10^{17}$ $cm^{-3}$, the backward break down voltage is abruptly reduced and break down occurs upon application of about 2 volts in the backward direction. Fig. 5 shows current and voltage characteristics at the Schottky junction formed directly on Al In As layer containing Si of $1 \times 10^{17}$ $cm^{-3}$. By referring to Fig. 5, it is understood that a high backward break down voltage cannot be obtained so far as the density of the impurity exceeds $1 \times 10^{17}$ $cm^{-3}$ . Fig. 6 shows a current voltage characteristic at the Schottky junction of the Schottky metal formed on Al In As layer in which Si is contained more than $1 \times 10^{18}$ $cm^{-3}$ near the substrate and Si is not contained in the region of 12 nm (120 A) from the upper surface of the Al In As layer. By Fig. 6, when the Schottky junction is formed on the portion containing low n-type impurity in Al In As layer, the backward break down voltage is higher than 6 volts.

As hereinafter described, the backward gate break down voltage of FETs can be increased. Therefore, a high drain voltage can be applied without causing break down in the gate of the FETs, namely the saturation characteristic of the drain voltage and current can be improved.

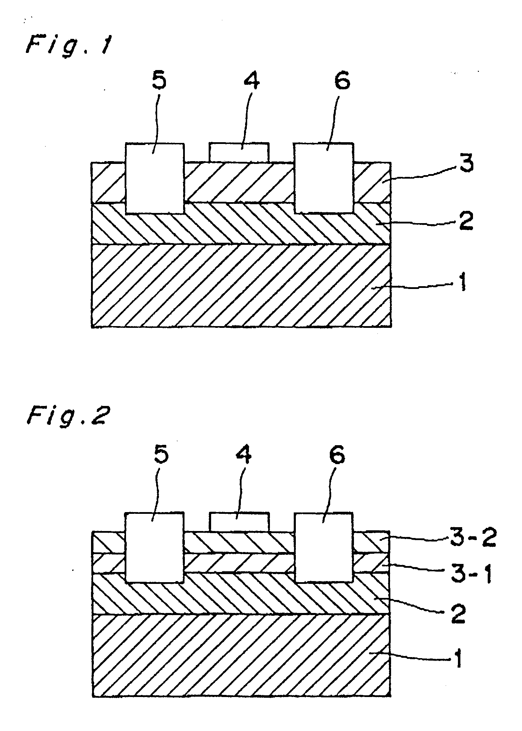

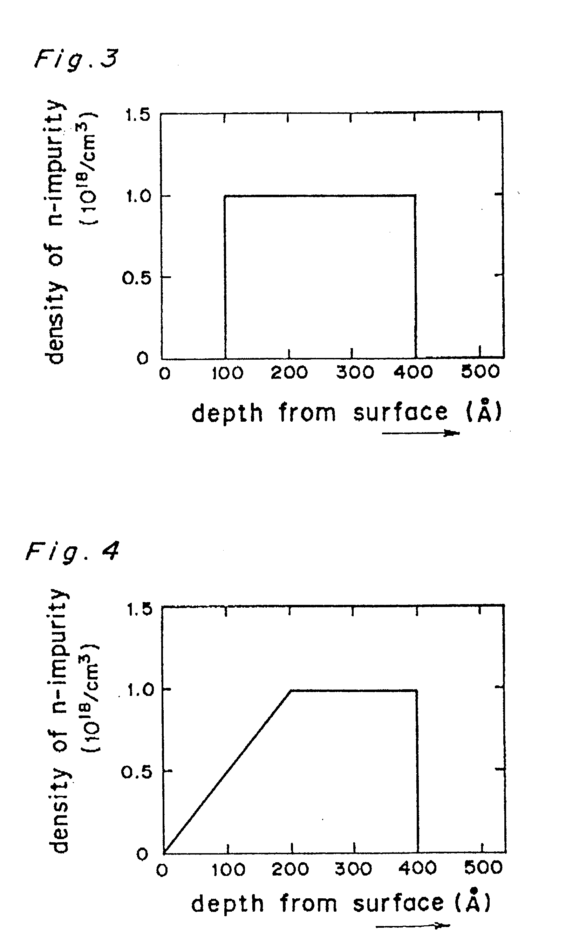

Referring to Fig. 1, Ga In As layer 2 is formed with a thickness of 1 micron by MBE method on a substrate 1 made of In P semiconductor. In order to improve the crystalline quality, a buffer layer (not shown) of Al In As layer may be formed between the substrate 1 and Ga In As layer 2. Subsequently, Al In As layer 3 is formed on the Ga In As layer 2 with a thickness of 40 nm (400 Å.) An n-type impurity such as Si is doped in the Al In As layer 3. The distribution of the n-type impurity in a direction of thickness is in such a manner that the impurity is absent in the range from the upper surface of the Al In As layer 3 to 10 nm (100 A) depth and the density of Si impurity in the range from 10 to 40 nm (100 to 400 A) depth is $10^{18}/cm^3$ as shown in Fig. 3. In place of the impurity distribution mentioned above, the density of the impurity may be increased linearly as the depth becomes large to 20 nm (200 Å) deep and the density of the impurity is constant in the range deeper than 20 nm (200 Å.) In any case it is essential that the density of the n-type impurity is minimized at the upper surface of the Al In As layer 3 and the density of the n-type impurity increases as the depth increases.

A gate metallized layer 4 is formed on the upper surface of the Al In As layer 3 using metal or metal compound such as Pt, Al, W or Silicide by way of evaporation or sputtering. A source metallized layer 5 and a drain metallized layer 6 are formed on both sides of the gate metallized layer 4 by evaporation so that the metallized layers reach the Ga In As layer 2. Both of the source and drain metallized layers are formed on the Ga In As layer using Au, Ge or Ni which forms an ohmic electrode by evaporation and the semiconductor device with the metallized layers is processed under a temperature of 400°C for 4 minutes.

Referring to Fig. 2 showing another embodiment of the present invention, the substrate 1 and Ga In As layer 2 are formed in the same manner as mentioned in the embodiment shown in Fig. 1. A first Al In As layer 3-1 is formed with 2 nm (20 Å) thickness on the Ga In As layer 2 and a second Al In As layer 3-2 is formed on the first Al In As layer 3-1 with 40 nm (400 Å) thickness. The second Al In As layer 3-2 is doped by n-type impurity such as Si. The distribution of the density of the impurity in the second layer 3-2 is such that the impurity is substantially 0 near the upper surface of the second layer 3-2 and the density increases as the depth increases in a stepped manner as shown in Fig. 3 or the density may be increased linearly as shown in Fig. 4. In any event it is essential that the density is low near the supper surface of the second layer and increases as the depth increases.

In the FETs shown in Fig. 1 or 2, upon application of a positive voltage to the gate electrode 4, electrons are induced in the Ga In As layer 2 and a conduction channel region can be formed near the hetero junction by a potential barrier defined on the interface between Al In As layer 3 (in case of Fig. 3 the first layer 3-1) and Ga In As layer 2. Thus a current can flow between the source metallized layer 5 and drain metallized layer 6 through the channel. The number of the electrons in the channel can be controlled by the voltage applied to the gate electrode 4, so that transconductance between the source electrode 5 drain electrode 6 can be controlled.

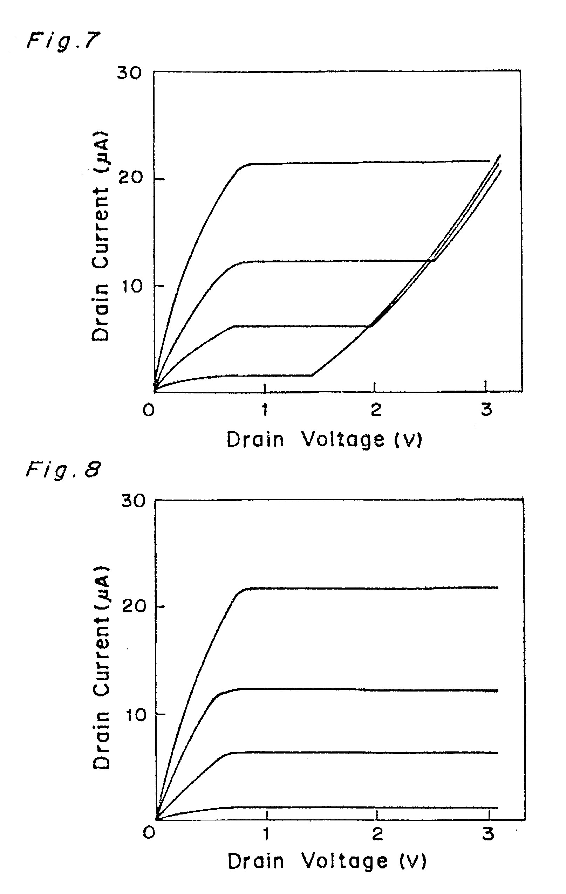

Fig. 8 shows graphs of drain current and drain voltage characteristics of the FET shown in Fig. 1 made by MBE method with 480°C of the substrate 1.

## Claims

1. A field effect transistor comprising:
   a substrate (1) made of semiinsulator or semiconductor of one conductivity type; working layers (2,3) formed on the substrate (1); a source region (5) and a drain region (6) provided in the working layer and a channel region between the source and drain region; and a gate electrode (4) formed on the channel region, said working layers comprising a first semiconductor layer (2) of mixed crystal formed on the substrate (1) and a second semiconductor layer (3) formed on the first semiconductor layer and made of mixed crystal containing n-type impurity in such a manner that the density of the impurity is lower in the region near the gate electrode (4) than in the region near the first semiconductor layer, characterized in that the mixed crystal in said first semiconductor layer (2) is GaInAs; the mixed crystal of said second semiconductor layer (3) is AlInAs; and said n-type impurity is substantially absent in a region of at least 5 nm depth measured from the surface of the second semiconductor layer (3).

2. A field effect transistor according to claim 1, wherein the density of the n-type impurity changes stepwise in the second semiconductor layer.

3. A field effect transistor according to claim 2 wherein the depth at which the density of the n-type impurity changes is in the range of 5 nm to 20 nm from the upper surface of the second semiconductor layer.

4. A field effect transistor according to claim 1, wherein the density of the n-type impurity changes monotonically as the depth increases.

5. A field effect transistor according to claim 4 wherein the density of the n-type impurity is less than $10^{17}$ $cm^{-3}$ in a region from the upper surface of the second semiconductor layer to 10 nm depth.

6. A field effect transistor comprising:
   a substrate (1) made of semiinsulator or semiconductor of one conductivity type; working layers (2,3) formed on the substrate (1); a source region (5) and drain region (6) provided in the working layer and channel region between the source and drain region; and a gate electrode (4) formed on the channel region, said working layers comprising a first semiconductor layer (2) of mixed crystal formed on the substrate (1), second semiconductor layer (3-1) of non-doped mixed crystal formed on the first semiconductor layer, and a third semiconductor layer (3-1) of mixed crystal containing n-type impurity in such a manner that the density of the impurity in the region near the gate electrode is lower than the density of the n-type impurity in the region near the second semiconductor layer, characterized in that the mixed crystal of said first layer is GaInAs; the mixed crystal of said second and third layers is AlInAs; and said n-type impurity is substantially absent in a region of at least 5 nm depth measured from the surface of the second semiconductor layer (2-2).

7. A field effect transistor according to claim 6, wherein the n-type impurity in the third semiconductor is changed stepwise at a predetermined depth.

8. A field effect transistor according to claim 7, wherein the depth at which the density of the n-type impurity changes is in the range of 5 nm to 20 nm from the upper surface of the third semiconductor layer and the density of the n-type impurity in the region nearest to the gate electrode is less than $10^{17}$ cm$^{-3}$.

9. A field effect transistor according to claim 6, wherein the density of the n-type impurity in the third semiconductor layer changes monotonically.

10. A field effect transistor according to claim 9, wherein the density of the n-type impurity of the third semiconductor layer is less than $10^{17}$ cm$^{-3}$ in a range from the upper surface of the third semiconductor layer to 10 nm depth.

**Patentansprüche**

1. Feldeffekttransistor umfassend:
   ein Substrat (1), hergestellt aus einem Halbisolator oder einem Halbleiter eines Leitfähigkeitstyps; Arbeitsschichten (2, 3), die auf dem Substrat (1) ausgebildet sind; einen Source-Bereich (5) und einen Drain-Bereich (6), die in der Arbeitsschicht vorgesehen sind, und einen Kanalbereich zwischen dem Source- und dem Drain-Bereich; und einer Gate-Elektrode (4), die auf dem Kanalbereich ausgebildet ist, wobei die Arbeitsschichten eine erste Halbleiterschicht (2) aus einem Mischkristall, die auf dem Substrat (1) ausgebildet ist, und eine zweite Halbleiterschicht (3) umfassen, die auf der ersten Halbleiterschicht ausgebildet ist und aus einem Mischkristall hergestellt ist, enthaltend eine n-Typ-Verunreinigung derart, daß die Dichte der Verunreinigung in dem Bereich nahe der Gate-Elektrode (4) geringer ist als in dem Bereich nahe der ersten Halbleiterschicht, dadurch **gekennzeichnet,** daß der Mischkristall in der ersten Halbleiterschicht (2) GaInAs ist; der Mischkristall der zweiten Halbleiterschicht (3) AlInAs ist; und die n-Typ-Verunreinigung in einem Bereich von zumindest 5 nm Tiefe, gemessen von der Oberfläche der zweiten Halbleiterschicht (3), im wesentlichen nicht vorhanden ist.

2. Feldeffekttransistor nach Anspruch 1, bei dem die Dichte der n-Typ-Verunreinigung sich schrittweise in der zweiten Halbleiterschicht ändert.

3. Feldeffekttransistor nach Anspruch 2, bei dem die Tiefe, bei der die Dichte der n-Typ-Verunreinigung sich ändert, im Bereich von 5 nm bis 20 nm von der oberen Oberfläche der zweiten Halbleiterschicht liegt.

4. Feldeffekttransistor nach Anspruch 1, bei dem die Dichte der n-Typ-Verunreinigung sich monoton ändert, wenn die Tiefe zunimmt.

5. Feldeffekttransistor nach Anspruch 4, bei dem die Dichte der n-Typ-Verunreinigung geringer ist als $10^{17}$ cm$^{-3}$ in einem Bereich von der oberen Oberfläche der zweiten Halbleiterschicht bis 10 nm Tiefe.

6. Feldeffekttransistor umfassend:
   ein Substrat (1), hergestellt aus einem Halbisolator oder Halbleiter eines ersten Leitfähigkeitstyps; Arbeitsschichten (2, 3), die auf dem Substrat (1) ausgebildet sind; einen Source-Bereich (5) und einen Drain-Bereich (6), die in der Arbeitsschicht ausgebildet sind, und einen Kanalbereich zwischen dem Source- und Drain-Bereich; und einer Gate-Elektrode (4), die auf dem Kanalbereich ausgebildet ist, wobei die Arbeitsschichten eine erste Halbleiterschicht (2) aus Mischkristall, die auf dem Substrat (1) ausgebildet ist, eine zweite Halbleiterschicht (3-1) aus nicht-dotiertem Mischkristall, die auf der ersten Halbleiterschicht ausgebildet ist, und eine dritte Halbleiterschicht (3-1) aus Mischkristall umfassen, enthaltend eine n-Typ-Verunreinigung derart, daß die Dichte der Verunreinigung in dem Bereich nahe der Gate-Elektrode geringer ist als die Dichte der n-Typ-Verunreinigung in dem Bereich nahe der zweiten Halbleiterschicht, dadurch **gekennzeichnet,** daß der Mischkristall der ersten Schicht GaInAs ist; der Mischkristall der zweiten und dritten Schicht AlInAs ist; und die n-Typ-Verunreinigung in einem Bereich von zumindest 5 nm Tiefe, gemessen von der Oberfläche der zweiten Halbleiterschicht (2-2), im wesentlichen nicht vorhanden ist.

7. Feldeffekttransistor nach Anspruch 6, bei dem die n-Typ-Verunreinigung in der dritten Halbleiterschicht schrittweise bei einer vorbestimmten Tiefe geändert wird.

8. Feldeffekttransistor nach Anspruch 7, bei dem die Tiefe, bei der die Dichte der n-Typ-Verunreinigung sich ändert, im Bereich von 5 nm bis 20 nm von der oberen Oberfläche der dritten Halbleiterschicht liegt und die Dichte der n-Typ-Verunreinigung in dem Bereich am nächsten zur Gate-Elektrode geringer ist als $10^{17}$ cm$^{-3}$.

9. Feldeffekttransistor nach Anspruch 6, bei dem die Dichte der n-Typ-Verunreinigung in der dritten Halbleiterschicht sich monoton ändert.

10. Feldeffekttransistor nach Anspruch 9, bei dem die Dichte der n-Typ-Verunreinigung der dritten Halbleiterschicht geringer ist als $10^{17}$ cm$^{-1}$ in einem Bereich von der oberen Oberfläche der dritten Halbleiterschicht bis 10 nm Tiefe.

**Revendications**

1. Transistor à effet de champ comprenant :
   un substrat (1) réalisé en un semi-isolant ou en un semiconducteur d'un type de conductivité donné ; des couches de fonctionnement (2, 3) formées sur le substrat (1) ; une région de source (5) et une région de drain (6) ménagées dans la couche de fonctionnement et une région de canal ménagée entre la région de source et la région de drain ; et une électrode de grille (4) formée sur la région de canal, lesdites couches de fonctionnement comprenant une première couche semiconductrice (2) de cristal mixte formée sur le substrat (1) et une seconde couche semiconductrice (3) formée sur la première couche semiconductrice et réalisée en cristal mixte qui contient une impureté de type N de telle sorte que la concentration de l'impureté dans la région située à proximité de l'électrode de grille (4) soit inférieure à celle observée dans la région située à proximité de la première couche semiconductrice ;
   caractérisé en ce que le cristal mixte de ladite première couche semiconductrice (2) est du GaInAs ; le cristal mixte de ladite seconde couche semiconductrice (3) est de l'AlInAs ; et ladite impureté de type N est sensiblement absente dans une région qui présente une profondeur d'au moins 5 nm telle que mesurée par rapport à la surface de la seconde couche semiconductrice (3).

2. Transistor à effet de champ selon la revendication 1, dans lequel la concentration de l'impureté de type N varie de manière étagée dans la seconde couche semiconductrice.

3. Transistor à effet de champ selon la revendication 2, dans lequel la profondeur à laquelle la concentration de l'impureté de type N varie se situe dans une plage comprise entre 5 nm et 20 nm par rapport à la surface supérieure de la seconde couche semiconductrice.

4. Transistor à effet de champ selon la revendication 1, dans lequel la concentration de l'impureté de type N varie de façon monotone lorsque la profondeur augmente.

5. Transistor à effet de champ selon la revendication 4, dans lequel la concentration de l'impureté de type N est inférieure à $10^{17}$ cm$^{-3}$ dans une région qui présente une profondeur qui va jusqu'à 10 nm par rapport à la surface supérieure de la seconde couche semiconductrice.

6. Transistor à effet de champ comprenant :
   un substrat (1) réalisé en un semi-isolant ou en un semiconducteur d'un type de conductivité donné ; des couches de fonctionnement (2, 3) formées sur le substrat (1) ; une région de source (5) et une région de drain (6) ménagées dans la couche de fonctionnement et une région de canal ménagée entre les régions de source et de drain ; et une électrode de grille (4) formée sur la région de canal, lesdites couches de fonctionnement comprenant une première couche semiconductrice (2) de cristal mixte formée sur le substrat (1), une seconde couche semiconductrice (3-1) de cristal mixte non dopé formée sur la première couche semiconductrice et une troisième couche semiconductrice (3-1) de cristal mixte qui contient une impureté de type N de telle sorte que la concentration en impureté de la région située à proximité de l'électrode de grille soit inférieure à la concentration en impureté de type N de la région située à proximité de la seconde couche semiconductrice, caractérisé en ce que le cristal mixte de ladite première couche est du GaInAs ; le cristal mixte desdites seconde et troisième couches et de l'AlInAs ; et ladite impureté de type N est sensiblement absente dans une région qui présente une profondeur d'au moins 5 nm par rapport à la surface de la seconde couche semiconductrice (2-2).

7. Transistor à effet de champ selon la revendication 6, dans lequel l'impureté de type N dans la troisième couche semiconductrice est modifiée de manière étagée au niveau d'une profondeur prédéterminée.

8. Transistor à effet de champ selon la revendication 7, dans lequel la profondeur à laquelle la concentration de l'impureté de type N varie se situe dans la plage qui va de 5 nm à 20 nm par rapport à la surface supérieure de la troisième couche semiconductrice et la concentration de l'impureté de type N dans la région la plus proche de l'électrode de grille est inférieure à $10^{17}$ cm$^{-3}$.

9. Transistor à effet de champ selon la revendication 6, dans lequel la concentration de l'impureté de type N dans la troisième couche semiconductrice varie de façon monotone.

10. Transistor à effet de champ selon la revendication 9, dans lequel la concentration de l'impureté de type N dans la troisième couche semiconductrice est inférieure à $10^{17}$ cm$^{-3}$ pour une plage qui va de la surface supérieure de la troisième couche semiconductrice jusqu'à une profondeur de 10 nm.

Fig.1

Fig.2

*Fig.3*

*Fig.4*

## Fig. 5

## Fig. 6

Fig.7

Fig.8